# EUROPEAN PATENT APPLICATION

(11) **EP 4 456 157 A1**
(43) Date of publication of application: **30.10.2024**
(21) Application number: 23170563.3
(22) Date of filing: 28.04.2023
(51) Int. Cl.: H01L 33/00, H01L 21/304

(54) **METHOD FOR REMOVING EPITAXIAL LAYER AND RESPECTIVE SEMICONDUCTOR STRUCTURE**

(71) Applicant: Micledi Microdisplays BV, 3000 Leuven (BE)
(72) Inventor: VERTOMMEN, Johan, 3220 Holsbeek (BE); STEUDEL, Soeren, 3020 Herent (BE)
(74) Representative: Körfer, Thomas

(57) **Abstract**

A method (100) and a semiconductor structure are provided. The method comprises the steps of providing (101) a semiconductor structure comprising at least one epitaxial layer, and a substrate having a first thickness, removing (102) the at least one epitaxial layer from the substrate in a predefined pattern to form a plurality of epitaxial isles on the substrate, and thinning (103) the substrate from a surface opposite to the plurality of epitaxial isles to a second thickness T2.

## Description

The invention relates to the processing of thick wafers, especially epitaxial wafers for integration with Si-CMOS wafers.

Generally, micro-LED display-based applications require tight pitched co-integration of a compound semiconductor with a Si-CMOS backplane. Some common integration schemes make use of the compound semiconductor, such as GaN, on a Si epitaxial wafer and a wafer-to-wafer hybrid bonding to connect to the Si-CMOS. In order to compensate for the stress caused by the epitaxial layer and to avoid a large bow, the epitaxial GaN is usually deposited on thick Si substrates, such as (111) Si substrates, either 1150pm on 200mm platform or 1550-2250pm on 300mm.

In general, the bow for 200mm equipment needs to be below 50pm and the bow for 300mm equipment needs to be below 150pm in order to comply with the specifications of standard CMOS production tools. One possible solution is to perform wafer reconstitution by dicing an epitaxial wafer and transforming the dies onto a target wafer. For example, EP 4 016 594 A1 presents such a reconstitution scheme.

Although this scheme is advantageous for achieving a high yield, especially due to the possibility of detecting good dies and transferring the good dies only onto the target wafer, the realization of such a reconstitution process is very complex.

Accordingly, an object of the invention is to provide a method and a semiconductor structure for stress-free epitaxial wafer handling in standard CMOS equipment.

The object is solved by the features of the first independent claim for the method and by the features of the second independent claim for the semiconductor structure. The dependent claims contain further developments.

According to a first aspect of the invention, a method is provided. The method comprises the steps of providing a semiconductor structure or arrangement comprising at least one epitaxial layer, and a substrate having a first thickness, removing the at least one epitaxial layer from the substrate in a predefined pattern to form a plurality of epitaxial isles on the substrate, and thinning the substrate from a surface opposite to the plurality of epitaxial isles to a second thickness.

Therefore, a stress relief of the epitaxial layer is implemented by patterning or structuring the epitaxial isles, especially with the size required for the application. Afterwards, the substrate is standardly thinned, e.g. grinded, down to a target thickness, e.g., to 775pm on 300mm substrate or less, for further processing, e.g. Si-CMOS integration.

Advantageously, the formation of the epitaxial isles by removing or etching the epitaxial layer may result in the reduction of stress caused by the epitaxial layer such that the thinning of the substrate may not result in wafer bow. Preferably, thinning the substrate comprises the steps of mounting the semiconductor structure on a dicing tape or a carrier wafer after forming the plurality of epitaxial isles, especially at a surface of the substrate comprising the plurality of epitaxial isles, grinding or etching the substrate from the surface opposite to the plurality of epitaxial isles to the second thickness, unmounting the semiconductor structure from the dicing tape or the carrier wafer, and planarizing the plurality of epitaxial isles.

Preferably, planarizing the plurality of epitaxial isles comprises the steps of depositing a dielectric material on the at least one epitaxial layer to entirely cover the plurality of epitaxial isles, and polishing the dielectric material.

Preferably, the method further comprises removing the at least one epitaxial layer from the substrate in the predefined pattern to form the plurality of epitaxial isles and a plurality of dummy epitaxial structures on the substrate.

Preferably, the method further comprises forming the plurality of dummy epitaxial structures in a non-overlapping manner with respect to the plurality of epitaxial isles on the substrate, preferably respectively between the plurality of epitaxial isles on the substrate.

Advantageously, the additional dummy epitaxial structures, especially realized in-between the epitaxial isles, may reduce or overcome the dishing effect, i.e. the effect of excessive thinning of the dielectric, during the planarization process, thereby allowing an easier planarization of the epitaxial isles.

Preferably, the epitaxial layer comprises or is a compound semiconductor layer, preferably a III-V compound semiconductor layer, e.g. a GaN epitaxial layer.

Preferably, the substrate comprises or is a silicon-substrate or a germanium-substrate.

Preferably, the predefined pattern comprises one or more of a predefined pitch value of the plurality of epitaxial isles, a predefined dimension of each of the plurality of epitaxial isles, a predefined pitch value of the plurality of dummy epitaxial structures, and a predefined dimension of each of the plurality of dummy epitaxial structures.

In other words, the predefined pattern comprises a predefined pitch value of the plurality of epitaxial isles and/or a predefined dimension of each of the plurality of epitaxial isles. Additionally or alternatively, the predefined pattern comprises a predefined pitch value of the plurality of dummy epitaxial structures and/or a predefined dimension of each of the plurality of dummy epitaxial structures.

Preferably, each of the plurality of epitaxial isles corresponds to a pixel or a display comprising a plurality of pixels. Additionally or alternatively, the predefined dimension of each of the plurality of epitaxial isles corresponds to a dimension of a pixel or a dimension of a display comprising a plurality of pixels.

For example, for a Full High Definition (FHD) display application with 3µm pitch, the dimension of each of the epitaxial isles may be about 4mm×6mm. In general, for micro-LED display applications, the dimension of each of the epitaxial isles may be between 2mm×2mm - 10mm×10mm. The dimension of the dummy epitaxial structures is significantly smaller than the dimension of the epitaxial isles.

Preferably, the first thickness of the substrate ranges from about 1150 - 2250 micrometers, preferably 1550 - 2250 micrometers, and the second thickness of the substrate is less than 800 micrometers, preferably less than or equal to 775 micrometers.

For example, for a 200mm substrate or wafer, the first thickness may be about 1150pm and the second thickness may be less than 725pm. For a 300mm substrate or wafer, the first thickness may be about 1550-2250pm and the second thickness may be about 775pm or less.

Preferably, removing the at least one epitaxial layer comprises dry etching or wet etching or dicing of the at least one epitaxial layer, especially laser dicing, stealth dicing, blade dicing, or plasma dicing. Suitable laser are among others a CO2-laser and doped YAG-lasers, such as a Nd:YAG-laser or a Er:YAG-laser.

In this regard, the dry etching may correspond to a chemical-based dry etching, e.g., using a plasma or reactive gases, or a physical etching, e.g., by momentum transfer, or a combination thereof. The wet etching may correspond to a chemical-based wet etching, e.g., Tetramethylammonium Hydroxide (TMAH) based wet etching.

Preferably, depositing a dielectric material comprises Chemical Vapor Deposition of the dielectric material, especially Low Pressure Chemical Vapor Deposition, Plasma Enhanced Chemical Vapor Deposition, or High-Density Plasma Chemical Vapor Deposition.

Preferably, the dielectric material comprises or is an oxide-based dielectric material, e.g. Silicon Oxide, or a nitride-based dielectric material, e.g. Silicon Nitride.

Preferably, polishing the dielectric material comprises Chemical Mechanical Polishing of the dielectric material, especially up to the plurality of epitaxial isles.

According to a second aspect of the invention, a semiconductor structure or device is provided. The semiconductor structure comprises a substrate having a thickness less than 800 micrometers, preferably less than or equal to 775 micrometers, and a plurality of epitaxial isles on the substrate. Each of the plurality of epitaxial isles comprises at least one epitaxial layer. In this regard, the plurality of epitaxial isles comprises a predefined pattern.

Preferably, the predefined pattern comprises a predefined pitch value of the plurality of epitaxial isles and/or a predefined dimension of each of the plurality of epitaxial isles.

Exemplary embodiments of the invention are now further explained with respect to the drawings by way of example only, and not for limitation. In the drawings:
- Fig. 1: shows an exemplary embodiment of the method according to the first aspect of the invention;
- Figs. 2A-2B: show different steps of a first exemplary embodiment of epitaxial isle formation;
- Figs. 2C-2E: show different steps of an exemplary process for substrate grinding;
- Fig. 2F: shows an exemplary process for dielectric deposition;
- Fig. 2G: shows a first exemplary embodiment of the semiconductor structure according to the second aspect of the invention;
- Fig. 3A: shows a second exemplary embodiment of epitaxial isle formation; and
- Fig. 3B: shows a second exemplary embodiment of the semiconductor structure according to the second aspect of the invention.

Reference will now be made in detail to the embodiments of the present invention, examples of which are illustrated in the accompanying drawings. However, the following embodiments of the present invention may be variously modified and the range of the present invention is not limited by the following embodiments.

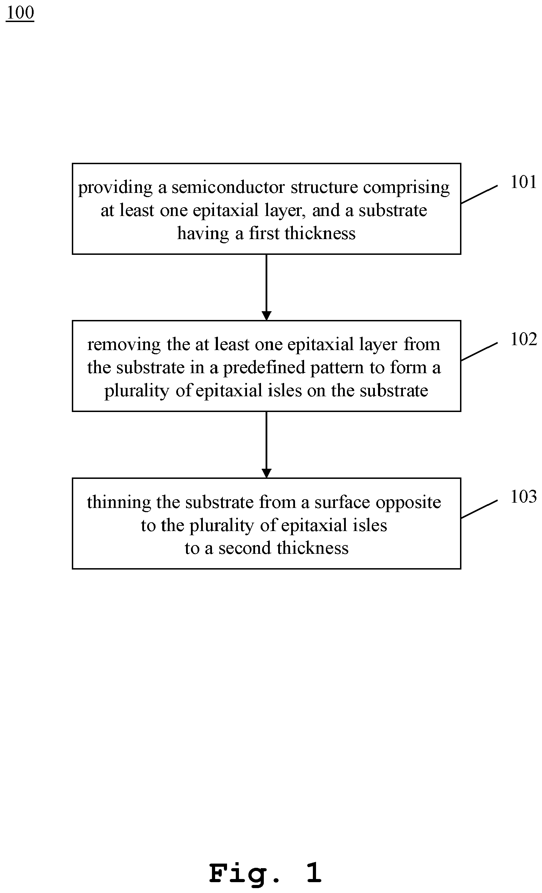

In Fig. 1, an exemplary embodiment of the method 100 according to the first aspect of the invention is illustrated. In a first step 101, a semiconductor structure comprising at least one epitaxial layer and a substrate having a first thickness is provided. In a second step 102, the at least one epitaxial layer is removed from the substrate in a predefined pattern to form a plurality of epitaxial isles on the substrate. In a third step 103, the substrate is thinned from a surface opposite to the plurality of epitaxial isles to a second thickness.

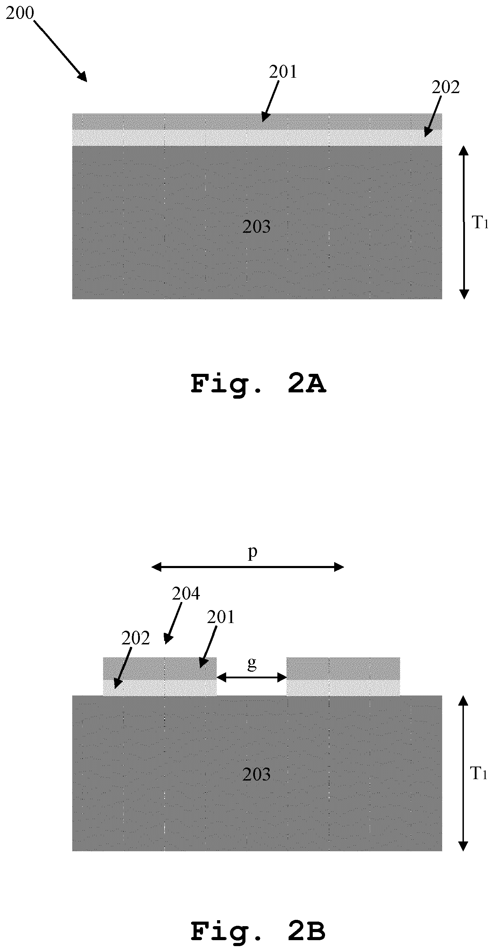

Along Figs. 2A-2B, a first exemplary embodiment of epitaxial isle formation is illustrated. In particular, Fig. 2A shows an incoming wafer or a semiconductor structure or arrangement 200 comprising an epitaxial layer 201, hereinafter referred as GaN active layer 201, followed by an epitaxial buffer layer 202, hereinafter referred as GaN buffer layer 202, and a substrate 203, hereinafter referred as Si-wafer 203.

The GaN active layer 201 and the GaN buffer layer 202 may be respectively grown or be deposited on the Si-wafer 203. The Si-wafer 203 may have an initial thickness T₁, for example, about 1150pm for 200mm Si-wafer or about 1550-2250pm for 300mm Si-wafer.

Fig. 2B shows the realization or formation of the epitaxial isles, hereinafter referred as GaN isles. In particular, the GaN active layer 201 and the GaN buffer layer 202 may be etched based on a predefined pattern to form the GaN isles 204.

In this regard, each of the GaN isles 204 may comprise the GaN active layer 201 and the GaN buffer layer 202. The etching may cause the GaN isles 204 having a gap g between two adjacent GaN isles 204 and/or a pitch p between two adjacent GaN isles 204. The predefined pattern may comprise the values g and/or p.

Additionally or alternatively, the predefined pattern may be based on the values g and/or p and/or the dimension of each of the GaN isles 204 required for a target application, e.g., FHD display application.

Preferably, the GaN isles 204 may be formed by applying photoresist coating and/or lithographic masks on the GaN active layer 201 based on the predefined pattern, and by etching the GaN active layer 201 and the GaN buffer layer 202 accordingly.

Further preferably, the etching may be performed via dry etching, e.g., using plasma or reactive gases or physical, or wet etching, e.g., TMAH-based etching, or dicing, e.g., laser dicing, stealth dicing, blade dicing, or plasma dicing.

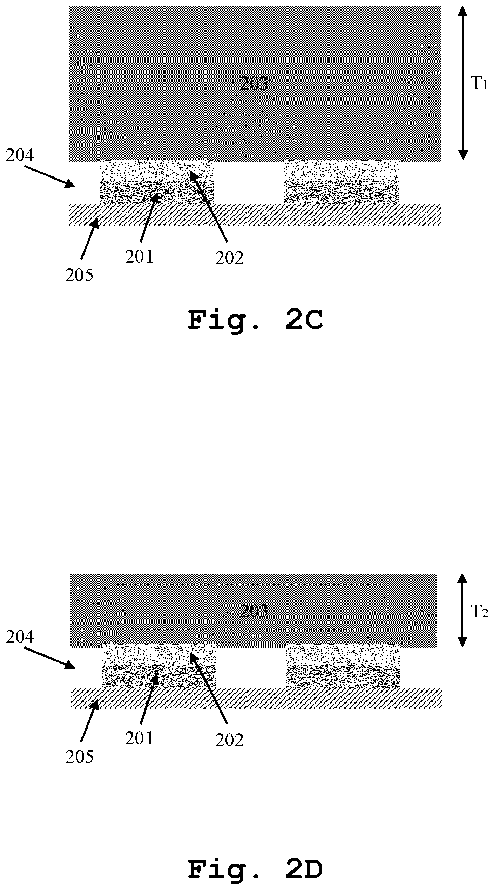

Along Figs. 2C-2E, an exemplary process for substrate grinding is illustrated. In particular, Fig. 2C shows a first step of the grinding process. In this regard, after the formation of the GaN isles 204, the semiconductor arrangement 200 is mounted on a dicing tape or a grinding tape or a carrier wafer or a support wafer 205, especially at the surface of the Si-wafer 203 containing the GaN isles 204 (front or top surface). As such, the arrangement may be flipped or be mounted upside down in order to expose the surface of the Si-wafer 203 opposite to the GaN isles 204 (back or bottom surface).

Fig. 2D shows a second step of the grinding process. In this process, the back or bottom surface of the Si-wafer 203 may be thinned or grinded to a target thickness T₂. For example, the target thickness T₂ may be less than 725pm for 200mm Si-wafer or less than or equal to 775pm for 300mm Si-wafer. Alternatively, the back or bottom surface of the Si-wafer 203 may be etched, e.g. wet etched or dry etched, to the target thickness T₂.

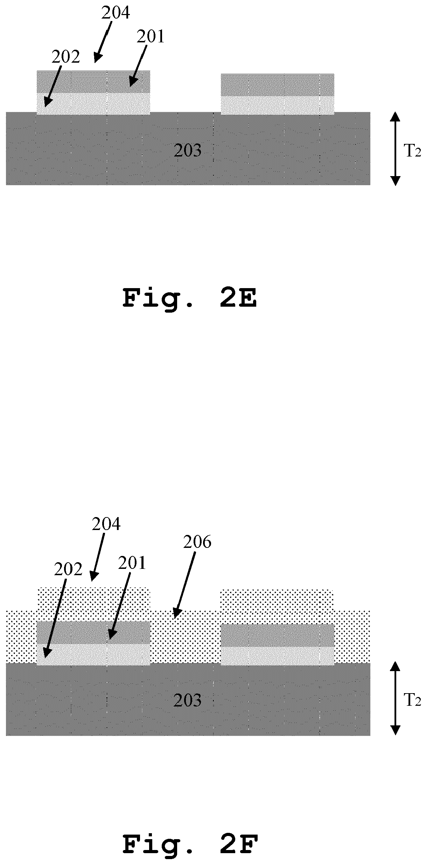

Fig. 2E shows a third step of the grinding process. In this regard, especially after thinning or grinding the back or bottom surface of the Si-wafer 203 to the target thickness T₂, the arrangement is unmounted from the dicing tape 205. Accordingly, after the arrangement is unmounted from the dicing tape 205, the arrangement may be flipped again to expose the GaN isles 204.

Along Figs. 2F-2G, an exemplary process for planarizing is illustrated. In particular, Fig. 2F shows a first step of the planarization process. In this regard, a dielectric material 206, such as SiO2, may be deposited to entirely cover the GaN isles 204, especially to electrically isolate the GaN isles 204 from each other. The dielectric material 206 may be deposited in multiple steps, especially to form a multi-layer stack with stress compensation. As such, the dielectric material 206 may comprise a multi-layer stack of said dielectric material for stress compensation.

For example, the deposition may be performed via Chemical Vapor Deposition (CVD) of the dielectric material, such as Low Pressure Chemical Vapor Deposition (LPCVD), Plasma Enhanced Chemical Vapor Deposition (PECVD), or High-Density Plasma Chemical Vapor Deposition (HDPCVD).

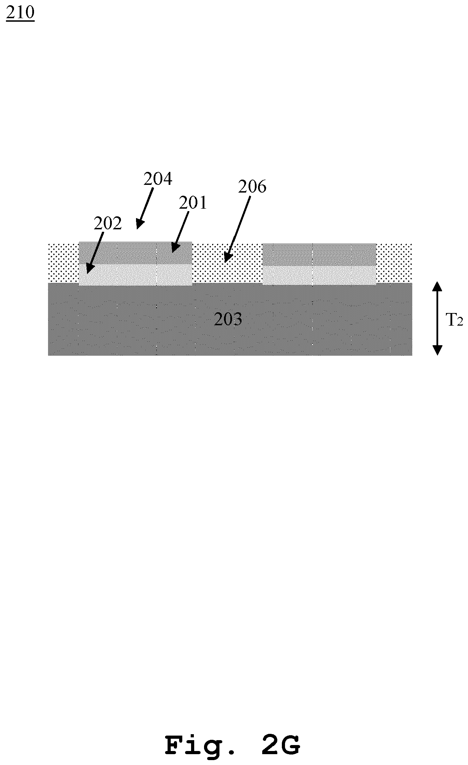

Fig. 2G shows a second step of the planarization process. Also in Fig. 2G, a first exemplary embodiment of the semiconductor structure or device 210 according to the second aspect of the invention is illustrated.

In this regard, the dielectric material 206 deposited onto the GaN isles 204 may be planarized or polished up to the GaN isles 204, especially via a Chemical Mechanical Polishing (CMP) process. Preferably, the dielectric material deposition and planarization steps may be repeated, for example 2 to 4 times.

Therefore, the semiconductor structure 210 comprises the Si-wafer 203 having the target thickness T₂, and the GaN isles 204 on the Si-wafer 203, where each of the GaN isles 204 comprises the GaN active layer 201 and the GaN buffer layer 202.

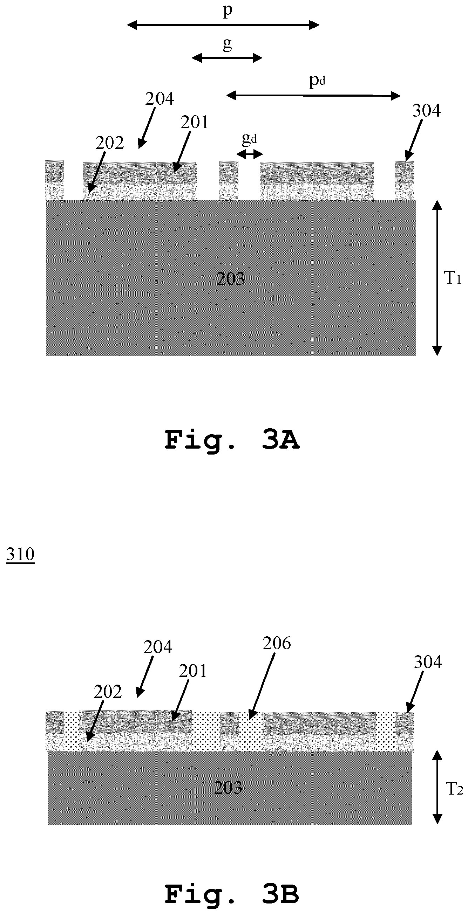

In Fig. 3A, a second exemplary embodiment of epitaxial isle formation is illustrated. Said formation may use the incoming wafer 200 of Fig. 2 comprising the GaN active layer 201, the GaN buffer layer 202, and the Si-wafer 203. Also, the Si-wafer 203 may have an initial thickness T₁, for example, about 1150pm for 200mm Si-wafer or about 1550-2250pm for 300mm Si-wafer.

Accordingly, the GaN active layer 201 and the GaN buffer layer 202 may be etched based on a predefined pattern to form the GaN isles 204 as well as to form dummy structures 304, especially outside the area of the GaN isles 204.

In this regard, each of the GaN isles 204 and each of the dummy structures 304 may comprise the GaN active layer 201 and the GaN buffer layer 202. The etching may cause the GaN isles 204 having a gap g between two adjacent GaN isles 204 and/or a pitch p between two adjacent GaN isles 204.

Furthermore, the etching may cause the dummy structures 304 having a gap g_{d} between a dummy structure 304 and a neighboring GaN isle 204 and/or a pitch p_{d} between two consecutive dummy structures 304. The value g_{d} may be preselected so as to realize a dummy structure 304 at about the mid-position between two adjacent GaN isles 204. Alternatively, the value g_{d} may vary along the gap g between two adjacent GaN isles 204.

The predefined pattern may comprise the values g and/or p and/or the dimension of each of the GaN isles 204 required for a target application, e.g., FHD display application. Additionally or alternatively, the predefined pattern may comprise the values g_{d} and/or p_{d} and/or the dimension of each of the dummy structures 304. Preferably, the dimension of the dummy structures 304 may be significantly smaller than the dimension of the GaN isles 204 in order not to affect the active area of the GaN isles 204.

Preferably, the GaN isles 204 and the dummy structures 304 may be formed by applying photoresist coating and/or lithographic masks, i.e., with additional mask pattern or design for the dummy structures 304, on the GaN active layer 201 based on the predefined pattern, and by etching the GaN active layer 201 and the GaN buffer layer 202 accordingly.

In Fig. 3B, a second exemplary embodiment of the semiconductor structure or device 310 according to the second aspect of the invention is illustrated. The semiconductor structure 310 may be realized by using the second exemplary embodiment of epitaxial isle formation according to Fig. 3A, and by analogously implementing the substrate grinding process according to Figs. 2C-2E and the planarization process according to Figs. 2F-2G.

In particular, the semiconductor structure 310 comprises the Si-wafer 203 having the target thickness T₂, the GaN isles 204 and the dummy structures 304 on the Si-wafer 203, where each of the GaN isles 204 and each of the dummy structures 304 comprise the GaN active layer 201 and the GaN buffer layer 202.

Therefore, out of incoming GaN on Si wafer with a thickness that may exceed the limit of what standard 200mm/300mm CMOS manufacturing tools can handle, the invention proposes a stress relieve pattern in the compound semiconductor layer and grind the wafer, especially with back-end tools, down to standard thickness followed by a front-side planarization. Afterwards, the wafer can be handed like a standard Si-wafer in standard CMOS front-end tools with the correct thickness and without bow.

Although the invention has been illustrated and described with respect to one or more implementations, equivalent alterations and modifications will occur to others skilled in the art upon the reading and understanding of this specification and the annexed drawings. In addition, while a particular feature of the invention may have been disclosed with respect to only one of several implementations, such feature may be combined with one or more other features of the other implementations as may be desired and advantageous for any given or particular application.

## Claims

1. A method (100) comprising:
providing (101) a semiconductor structure (200) comprising at least one epitaxial layer (201), and a substrate (203) having a first thickness (T₁);
removing (102) the at least one epitaxial layer (201) from the substrate (203) in a predefined pattern to form a plurality of epitaxial isles (204) on the substrate (203); and
thinning (103) the substrate (203) from a surface opposite to the plurality of epitaxial isles (204) to a second thickness (T₂).

2. The method according to claim 1,
wherein thinning the substrate (203) comprises:
mounting the semiconductor structure (200) on a dicing tape or a carrier wafer (205) after forming the plurality of epitaxial isles (204), especially at a surface of the substrate (203) comprising the plurality of epitaxial isles (204) ;
grinding or etching the substrate (203) from the surface opposite to the plurality of epitaxial isles (204) to the second thickness (T₂);
unmounting the semiconductor structure (200) from the dicing tape or the carrier wafer (205); and
planarizing the plurality of epitaxial isles (204).

3. The method according to claim 2,
wherein planarizing the plurality of epitaxial isles (204) comprises:
depositing a dielectric material (206) on the at least one epitaxial layer (201) to entirely cover the plurality of epitaxial isles (204); and
polishing the dielectric material (206).

4. The method according to any of claims 1 to 3,
wherein the method further comprises removing the at least one epitaxial layer (201) from the substrate (203) in the predefined pattern to form the plurality of epitaxial isles (204) and a plurality of dummy epitaxial structures (304) on the substrate (203).

5. The method according to claim 4,
wherein the method further comprises forming the plurality of dummy epitaxial structures (304) in a non-overlapping manner with respect to the plurality of epitaxial isles (204) on the substrate (203), preferably respectively between the plurality of epitaxial isles (204) on the substrate (203).

6. The method according to any of claims 1 to 5,
wherein the epitaxial layer (201) comprises or is a compound semiconductor layer, preferably a III-V compound semiconductor layer, and/or
wherein the substrate (203) comprises or is a silicon-substrate or a germanium-substrate.

7. The method according to any of claims 1 to 6,
wherein the predefined pattern comprises one or more of a predefined pitch value of the plurality of epitaxial isles (204), a predefined dimension of each of the plurality of epitaxial isles (204), a predefined pitch value of the plurality of dummy epitaxial structures (304), and a predefined dimension of each of the plurality of dummy epitaxial structures (304).

8. The method according to claim 7,
wherein each of the plurality of epitaxial isles (204) corresponds to a pixel or a display comprising a plurality of pixels, and/or
wherein the predefined dimension of each of the plurality of epitaxial isles (204) corresponds to a dimension of a pixel or a dimension of a display comprising a plurality of pixels.

9. The method according to any of claims 1 to 8,
wherein the first thickness (T₁) of the substrate (203) ranges from about 1150 - 2250 micrometers, preferably 1550 - 2250 micrometers, and the second thickness (T₂) of the substrate (203) is less than 800 micrometers, preferably less than or equal to 775 micrometers.

10. The method according to any of claims 1 to 9,
wherein removing the at least one epitaxial layer (201) comprises dry etching or wet etching or dicing of the at least one epitaxial layer (201), especially laser dicing, stealth dicing, blade dicing, or plasma dicing.

11. The method according to claim 3,
wherein depositing a dielectric material (206) comprises Chemical Vapor Deposition of the dielectric material (206), especially Low Pressure Chemical Vapor Deposition, Plasma Enhanced Chemical Vapor Deposition, or High-Density Plasma Chemical Vapor Deposition.

12. The method according to claim 3,
wherein the dielectric material (206) comprises or is an oxide-based dielectric material or a nitride-based dielectric material.

13. The method according to claim 3,
wherein polishing the dielectric material (206) comprises Chemical Mechanical Polishing of the dielectric material (206), especially up to the plurality of epitaxial isles.

14. A semiconductor structure (210) comprising:
a substrate (203) having a thickness (T₂) less than 800 micrometers, preferably less than or equal to 775 micrometers, and
a plurality of epitaxial isles (204) on the substrate (203), each of the plurality of epitaxial isles (204) comprises at least one epitaxial layer (201),
wherein the plurality of epitaxial isles (204) comprises a predefined pattern.

15. The semiconductor structure according to claim 14, wherein the predefined pattern comprises a predefined pitch value of the plurality of epitaxial isles (204) and/or a predefined dimension of each of the plurality of epitaxial isles (204).
